# EUROPEAN PATENT APPLICATION

(11) **EP 3 190 639 A1**
(43) Date of publication of application: **12.07.2017**
(21) Application number: 14892231.3
(22) Date of filing: 01.12.2014
(51) Int. Cl.: H01L 51/50, H01L 51/54, H01L 51/56

(54) **ORGANIC ELECTROLUMINESCENT DISPLAY, MANUFACTURING METHOD THEREOF AND DISPLAY DEVICE**

(30) Priority: 04.09.2014 CN 201410448648
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: ZHANG, Jinzhong, Beijing 100176 (CN)
(74) Representative: Gesthuysen, Michael
(86) International application number: PCT/CN2014/092670
(87) International publication number: WO 2016/033882

(57) **Abstract**

The present invention discloses an organic electroluminescent display device, a fabricating method thereof and a display device, comprising a substrate, a hole injection layer, a hole transport layer and an electron blocking layer arranged on the substrate successively, wherein the material of the hole transport layer is a material with P-type doping, the LUMO energy level of the P-type doping is relatively close to the HOMO energy level of the bulk material of the hole transport layer, hence, transition of the electrons in the HOMO energy level of the bulk material of the hole transport layer to the LUMO energy level of the P-type doping is enabled, thereby increasing the amout of free hole current carriers in the hole transport layer, and improving mobility of the hole current carrier, thus, it is convenient for increasing the probability of combining the electrons and the holes in the luminescent layer to form electron-hole pairs, so as to improve the balance degree of the electron-hole pairs, thereby improving luminescent performance of the OLED.

## Description

### FIELD OF THE INVENTION

The present invention relates to the field of display technology, particularly to an organic electroluminescent display device, a fabricating method thereof and a display device.

### BACKGROUND OF THE INVENTION

At present, the organic electroluminescent display device (OLED) has become the mainstream of the display field gradually by virtue of its excellent performance such as low power consumption, high color saturation, wide visual angle, small thickness, and flexibility.

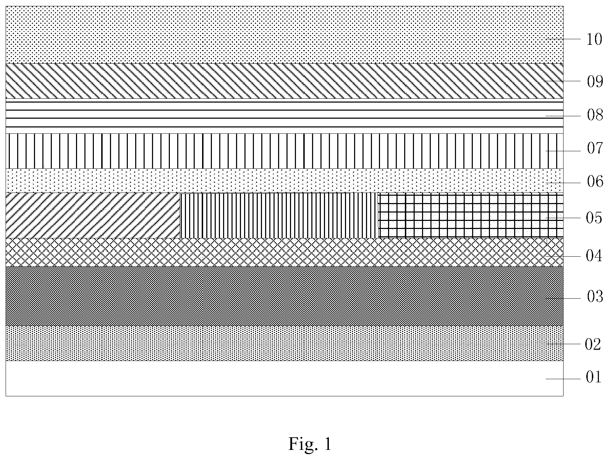

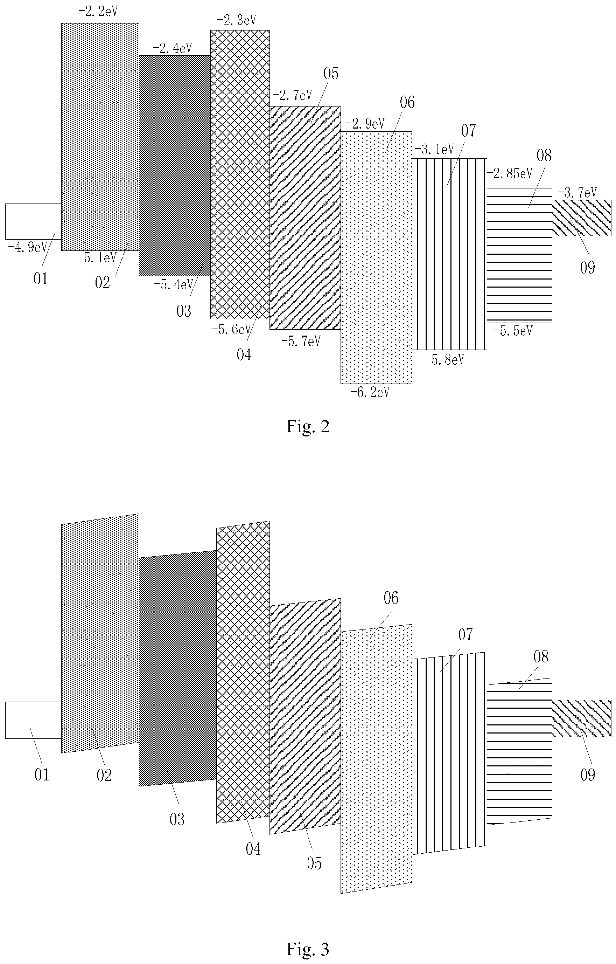

The basic structure of the OLED, as shown in Fig. 1, comprises: an anode 01, a hole injection layer 02, a hole transport layer 03, an electron blocking layer 04, a luminescent layer 05, a hole blocking layer 06, an electron transport layer 07, an electron injection layer 08, a cathode 09 and a cathode protection layer 10 arranged successively. When the OLED is not applied with a voltage, the energy levels of respective materials are not tilted, the schematic view of structure of the energy level is as shown in Fig. 2; when a voltage is applied between the anode 01 and the cathode 09 of the OLED so as to form an electric current, the electrons in the cathode 09 are transported via the electron injection layer 08, the electron transport layer 07 and the hole blocking layer 06, while the holes in the anode 01 are transported via the hole injection layer 02, the hole transport layer 03 and the electron blocking layer 04, then the electrons and the holes are combined to form electron-hole pairs in the luminescent layer 05, to activate the material in the luminescent layer 05 to emit light, this process enables the energy levels of respective materials to be tilted because a voltage is applied between the cathode 09 and the anode 01, the schematic view of structure of the energy level is as shown in Fig. 3.

Since the highest occupied molecular orbital (HOMO) energy level difference between the hole transport layer 03 and the electron blocking layer 04 formed using the prior art is relatively large, thus that it is not easy for the holes to get across the potential barrier between the hole transport layer 03 and the electron blocking layer 04; meanwhile, the relatively large HOMO difference between the hole injection layer 02 and the hole transport layer 03 also impedes transport of the holes, such that the hole transport efficiency is reduced and the luminescent efficiency of the OLED device is not high.

### SUMMARY OF THE INVENTION

In view of this, the embodiment of the present invention provides an organic electroluminescent display device, a fabricating method thereof and a display device, which can increase the amount of the free hole current carriers in the hole transport layer and improve the mobility of the hole current carrier, thereby improving luminescent performance of the OLED.

Therefore, the embodiment of the present invention provides an organic electroluminescent display device, comprising: a substrate, a hole injection layer, a hole transport layer and an electron blocking layer arranged on the substrate successively, the material of the hole transport layer is a material with P-type doping.

In a possible implementing mode, in the above organic electroluminescent display device provided by the embodiment of the present invention, the doping concentration of the P-type doping presents gradient variation, so that the energy level of the hole transport layer presents gradient variation; wherein,
the doping concentration of the P-type doping close to the hole injection layer is higher than the doping concentration close to the electron blocking layer.

In a possible implementing mode, in the above organic electroluminescent display device provided by the embodiment of the present invention, the highest occupied molecular orbital energy level difference between the hole transport layer and the electron blocking layer is less than the highest occupied molucular orbital energy level difference between the undoped hole transport layer and the electron blocking layer.

In a possible implementing mode, in the above organic electroluminescent display device provided by the embodiment of the present invention, the highest occupied molecular orbital energy level difference between the hole injection layer and the hole transport layer is less than the highest occupied molecular orbital energy level difference between the hole injection layer and the undoped hole transport layer.

In a possible implementing mode, in the above organic electroluminescent display device provided by the embodiment of the present invention, the minimum doping concentration of the P-type doping is 1%, the maximum doping concentration of the P-type doping is 6%.

In a possible implementing mode, in the above organic electroluminescent display device provided by the embodiment of the present invention, the dopant used by the hole transport layer is P-type oxidant.

In a possible implementing mode, in the above organic electroluminescent display device provided by the embodiment of the present invention, the P-type oxidant is any one of antimony pentachloride, iron chloride, iodine, 2,3,5,6-Tetrafluoro-7,7,8,8-tetracyanoquinodimethane (F₄-TCNQ) or tris(4-bromophenyl)aminium hexachloroantimonate (TBAHA).

The embodiment of the present invention further provides a fabricating method of the above organic electroluminescent display device provided by the embodiment of the present invention, comprising forming a hole injection layer, a hole transport layer and an electron blocking layer successively on a substrate, wherein forming the hole tansport layer on the substrate specifically comprises:
forming the hole transport layer on the substrate on which the hole injection layer is formed by evaporating a bulk and the P-type doping together in the evaporation chamber.

In a possible implementing mode, in the fabricating method of the above organic electroluminescent display device provided by the embodiment of the present invention, forming the hole transport layer on the substrate further comprises:
controlling the concentration of the P-type doping in the formed hole transport layer by controlling the temperature for evaporating the P-type doping.

The embodiment of the present invention further provides a display device comprising the above organic electroluminescent display device provided by the embodiment of the present invention.

The beneficial effects of the present invention are as follows:
The organic electroluminescent display device, the fabricating method thereof and the display device provided by the embodiment of the present invention, comprise a substrate, a hole injection layer, a hole transport layer and an electron blocking layer arranged on the substrate successively, wherein the material of the hole transport layer is a material with P-type doping, the LUMO energy level of the P-type doping is relatively close to the HOMO energy level of the bulk material of the hole transport layer, hence, transition of the electrons in the HOMO energy level of the bulk material of the hole transport layer to the LUMO energy level of the P-type doping is enabled, thereby increasing the amout of free hole current carriers in the hole transport layer, and improving mobility of the hole current carrier, thus, it is convenient for increasing the probability of combining the electrons and the holes in the luminescent layer to form electron-hole pairs, so as to improve the balance degree of the electron-hole pairs, thereby improving luminescent performance of the OLED.

### BRIEF DESCRIPTION OF DRAWINGS

Fig. 1 is a schematic view of structure of an organic electroluminescent display device in the prior art;
Fig. 2 is a schematic view of structure of energy level when the organic electroluminescent display device in the prior art is not applied with a voltage;
Fig. 3 is a schematic view of structure of energy level when the organic electroluminescent display device in the prior art is applied with a voltage;
Fig. 4a and Fig. 4b are schematic views of structure of an organic electroluminescent display device provided by the embodiment of the present invention;
Fig. 5 is a schematic view of structure of energy level when the organic electroluminescent display device provided by the embodiment of the present invention is not applied with a voltage;
Fig. 6 is a schematic view of structure of energy level when the organic electroluminescent display device provided by the embodiment of the present invention is applied with a voltage.

### DETAILED DESCRIPTION OF THE INVENTION

Next, the specific implementing modes of the organic electroluminescent display device, the fabricating method thereof and the display device provided by the embodiment of the present invention will be explained in detail with reference to the drawings.

Wherein, the thickness of the shape of the films in the drawings do not reflect the real proportion of the organic electroluminescent display device, which only aims to schematiclly explaining the contents of the present invention.

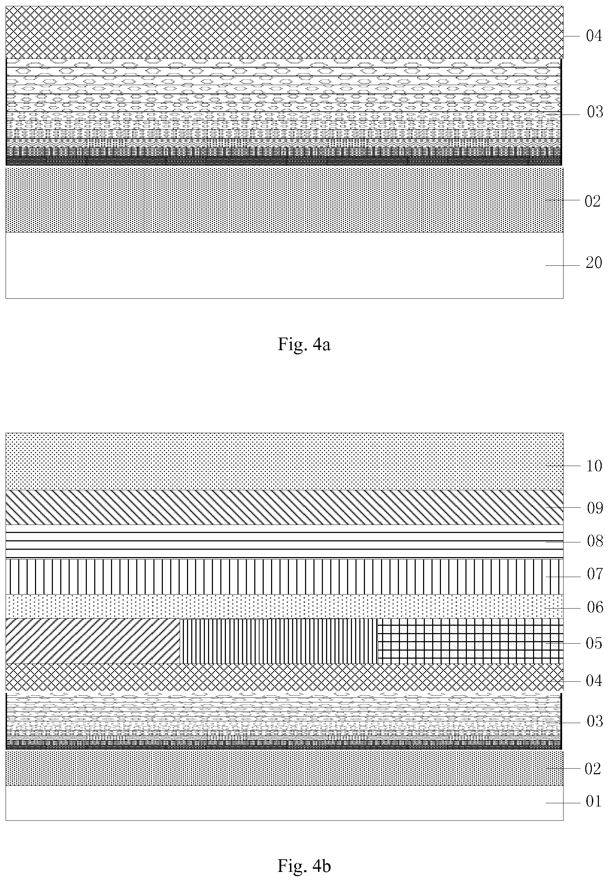

The embodiment of the present invention provides an organic electroluminescent display device, as shown in Fig. 4a, comprising: a substrate 20, a hole injection layer 02, a hole transport layer 03 and an electron blocking layer 04 arranged successively on the substrate 20; wherein the material of the hole transport layer 03 is a material with P-type doping.

Since the material of the hole transport layer 03 in the above organic electroluminescent display device provided by the embodiment of the present invention is doped with P-type material, and the LUMO energy level of the P-type doping is relatively close to the HOMO energy level of the bulk material of the hole transport layer 03, hence, transition of the electrons in the HOMO energy level of the bulk material of the hole transport layer 03 to the LUMO energy level of the P-type doping is enabled, thereby increasing the amout of free hole current carriers in the hole transport layer 03, and improving mobility of the hole current carrier, thus, it is convenient for increasing the probability of combining the electrons and the holes in the luminescent layer to form electron-hole pairs, so as to improve the balance degree of the electron-hole pairs, thereby improving luminescent performance of the OLED.

Specifically, in the above organic electroluminescent display device provided by the embodiment of the present invention, with the change of the concentration of the P-type doping, the energy level of the hole transport layer 03 also changes accordingly, hence, the energy level of the hole transport layer 03 can be adjusted by adjusting the concentration of the P-type doping in the hole transport layer 03.

In specific implementation, the doping concentration of the P-type doping in the hole transport layer 03 can be adjusted to present graident variation, so that the energy level of the hole transport layer 03 also present gradient variation; wherein the doping concentration of the P-type doping close to the hole injection layer 02 can be controlled to be higher than the doping concentration close to the electron blocking layer 04 specifically, as shown in Fig. 4a, i.e., reducing the concentration of the P-type doping gradually in the process of forming the hole transport layer 03, in this way, the highest occupied molecular orbital energy level of the hole transport layer 03 near the hole injection layer 02 can be closer to the highest occupied molecular orbital energy level of the hole injection layer 02, the highest occupied molecular orbital energy level near the electron blocking layer 04 is closer to the highest occupied molecular orbital energy level of the electron blocking layer 04.

In specific implementation, the concentration of the P-type doping in the hole transport layer 03 near the electron blocking layer 04 can be adjusted, i.e., adjusting the minimum doping concentration of the P-type doping, so that the highest occupied molecular orbital energy level difference between the hole transport layer 03 and the electron blocking layer 04 is less than the highest occupied molucular orbital energy level difference between the undoped hole transport layer 03 and the electron blocking layer 04, in this way, the HOMO potential barrier between the hole transport layer 03 and the electron blocking layer 04 can be reduced, so as to increase the hole transport efficiency and enhance the luminescent efficiency of the whole OLED device.

In specific implementation, the concentration of the P-type doping in the hole transport layer 03 near the hole injection layer 2 can also be adjusted, i.e., adjusting the maximum doping concentration of the P-type doping, so that the highest occupied molecular orbital energy level difference between the hole injection layer 03 and the hole transport layer 02 is less than the highest occupied molecular orbital energy level difference between the undoped hole transport layer 03 and the hole injection layer 02, in this way, the HOMO potential barrier between the hole transport layer 03 and the hole injection layer 02 can be reduced, so as to increase the hole transport efficiency and enhance the luminescent efficiency of the whole OLED device.

In specific implementation, the doping concentration of the P-type doping in the hole transport layer 03 can be controlled to achieve the above purposes, specifically, the minimum doping concentration of the P-type doping is preferably controlled at 1% generally, the maximum doping concentration of the P-type doping is preferably controlled at 6% generally.

In specific implementation, in the above organic electroluminescent display device provided by the embodiment of the present invention, the dopant generally used by the hole transport layer 03 is a P-type oxidant.

Generally, in specific implementation, in the above organic electroluminescent display device provided by the embodiment of the present invention, the P-type exidant is any one of antimony pentachloride, iron chloride, iodine, F₄-TCNQ or TBAHA.

In specific implementation, the material of the hole transport layer 03 generally selects NPB or biphenyl diamine derivatives etc., the material of the hole injection layer 02 may be copper phthalocyanine, PEDT, PSS or TNANA etc.

In specific implementation, in the above organic electroluminescent display device provided by the embodiment of the present invention, as shown in Fig. 4b, it generally further comprises film layers such as a luminescent layer 05, a hole blocking layer 06, an electron transport layer 07, an electron injection layer 08, a cathode 09 and a cathode protection layer 10 arranged successively on the electron blocking layer 04; moreover, film layers such as a buffer layer, a polycrystalline silicon layer, a gate layer, a gate insulating layer, an ILD layer, a SD layer, a PVX layer, an organic resin PLN layer, an anode 01, a pixel definition layer (PDL layer) are also generally arranged between the substrate 20 and the hole injection layer 02, Fig. 4b only shows the anode 01.

Specifically, the anode 01 can use the ITO/Ag/ITO structure specifically, its thickness may adopt 500A/100A/500A specifically.

Specifically, the luminescent layer 05 can consist of a green light luminescent layer, a red light luminescent layer and a blue light luminescent layer. The above three kinds of luminescent layers can be classified into fluorescent luminescent layer and phosphorescent luminescent layer. The phosphorescence of the red luminescent layer can be 4-(Dicyanomethylene)-2-tert-butyl-6-(1,1,7,7-tetramethyljulolidin-4-yl-vinyl )-4H-pyran (DCJTB) like derivatives, star-shaped DCM derivatives, polycyclic aromatic hydrocarbons or non doped red fluorescent material containing D/A architecture. The green fluorescent material includes quinacridone derivatives, coumarin derivatives, polycyclic aromatic hydrocarbons. The blue fluorescent material includes diaryl anthracene derivatives, diphenyl ethylene araomatic derivatives, pyrene derivatives, spirobifluorene derivatives, TBP,DSA-Ph, IDE-102 etc. The phosphorescent luminescent main body material may be main luminescent body material containing carbazole groups, main luminescent body material with electron transport property etc. Whereas the phosphorescent doping material of red, green, and blue may be Pt complex, Ir complex, Eu complex, Os complex or FIrpic etc.

Specifically, the material of the hole blocking layer 06 may be BCP.

Specifically, the material of the electron transport layer 07 may be quinoline derivatives, phenazine derivatives, heterocyclic compounds containing silicon, quinoxaline derivatives, dinitrogen phenanthrene derivatives or perfluorination oligomer.

Specifically, the material of the electron injection layer 08 may be alkali metal oxide e.g., Li₂O, LiBO₂, K₂SiO₃, Cs₂CO₃, and may also be alkali metal acetate, and may also be alkali metal fluoride.

Specifically, the material of the cathode 09 may be Li:Al alloy or Mg:Ag alloy.

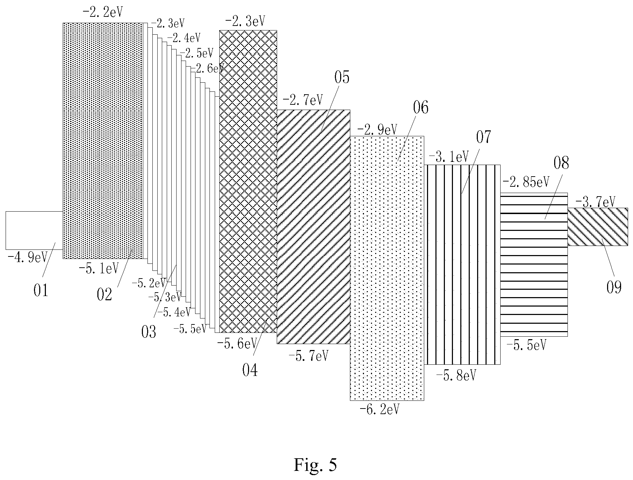

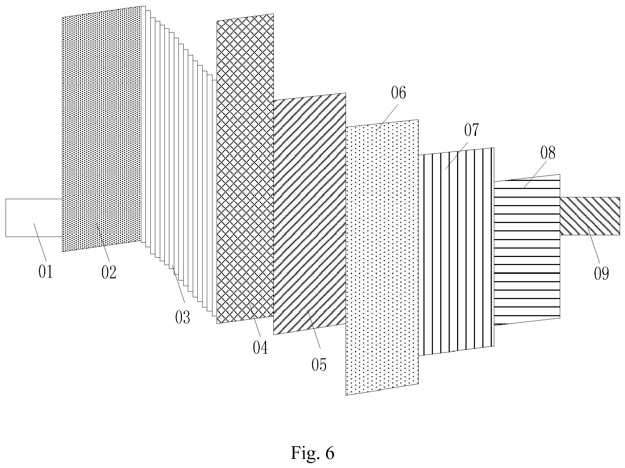

Specifically, the specific structure of the above organic electroluminescent display device provided by the embodiment of the present invention is as shown in Fig. 4b, when no voltage is applied between the anode 01 and the cathode 09, the energy levels of respective materials are not tilted, the schematic view of structure of the energy level is as shown in Fig. 5, here the energy level of the hole transport layer 03 presents gradient variation, the amount of the free hole current carriers in the hole transport layer 03 is larger than that when it is not doped; when a voltage is applied between the anode 01 and the cathode 09 of the doped OLED so as to form an electric current, the energy levels of respective materials are tilted, the schematic view of structure of the energy level is as shown in Fig. 6, this energy level structure can improve transport ability of the hole relative to the prior energy level structure, thus it is convenient for increasing the probability of combining the electrons and the holes in the luminescent layer to form electro-hole pairs, which is benefit for activating the material in the luminescent layer to emit light.

Based on the same inventive concept, the embodiment of the present invention further provides a fabricating method of the above organic electroluminescent display device provided by the embodiment of the present invention, since the principle of the method for solving problem is similar as the preceding organic electroluminescent display device, the implementation of the method may refer to the implementation of the organic electroluminescent display device, which will not be repeated here.

In specific implementation, the fabricating method of the above organic electroluminescent display device provided by the embodiment of the present invention comprises forming a hole injection layer, a hole transport layer and an electron blocking layer successively on a substrate, wherein forming the hole tansport layer on the substrate specifically comprises:
forming the hole transport layer on the substrate on which the hole injection layer is formed by evaporating the bulk and the P-type doping together in the evaporation chamber.

Further, in specific implementation, in the fabricating method of the above organic electroluminescent display device provided by the embodiment of the present invention, forming the hole transport layer on the substrate further comprises:
controlling the concentration of the P-type doping in the formed hole transport layer by controlling the temperature for evaporating the P-type doping, so that the P-type doping in the formed hole transport layer presents gradient variation.

In specific implementation, in the process of evaporating the bulk and the P-type doping together in the evaporation chamber through the vacuum heat evaporation method to form the hole transport layer on the substrate on which the hole injection layer is formed, the temperature of the evaporation source can be controlled, the evaporating rate of the P-type doping can be reduced by reducing the temperature for evaporating the P-type doping, thereby reducing the doping concentration of the P-type doping, so that the doping concentration of the P-type doping presents gradient variation, and the energy level of the hole transport layer also presents gradient variation, in this way, the amount of free hole current carriers in the hole transport layer can be increased, and the mobility of the hole current carrier can be improved, thereby improving luminescent performance of the OLED and fabricating an OLED device of high efficiency.

Next, a specific example will be taken to explain the fabricating method of the organic electroluminescent display device provided by the embodiment of the present invention specifically, the specific steps are as follows:
1. Forming an anode layer on the substrate, the formed anode layer is an ITO/Ag/ITO structure, the thickness is 500A/100A/500A;
2. In the high vacuum evaporation chamber, forming a hole injection layer on the substrate on which the anode layer is formed by evaporating the bulk together in the evaporation chamber, wherein the hole injection layer is deposited using a mask plate of high precision, the material of the hole injection layer includes copper phthalocyanine, PEDT, PSS or TNANA;
3. In the high vacuum evaporation chamber, forming a hole transport layer on the substrate on which the hole injection layer is formed by evaporating the bulk and the P-type doping together in the evaporation chamber, wherein the hole transport layer is deposited using a mask plate of high precision, the material of the hole transport layer includes NPB or biphenyl diamine derivatives, meanwhile, the material of the P-doping may be antimony pentachloride, iron chloride, iodine, F₄-TCNQ or TBAHA etc., and may also be homemade oxidant;
4. In the high vacuum evaporation chamber, forming an electron blocking layer on the substrate on which the hole transport layer is formed by evaporating the bulk together in the evaporation chamber, wherein the electron blocking layer is deposited using a mask plate of high precision, the electron blocking layer can block transport of the electrons while not blocking transport of the holes;
5. In the next high vacuum evaporation chamber, forming a luminescent layer on the substrate on which the electron blocking layer is formed by evaporating the bulk separately in the evaporation chamber, wherein the luminescent layer is deposited using a mask plate of high precision, the luminescent layer may be a red light luminescent layer, a green light luminescent layer and a blue light luminescent layer. The above three kinds of luminescent layers can be classified into fluorescent luminescent layer and phosphorescent luminescent layer, wherein the material of the red fluorescent luminescent layer includes DCJTB derivatives, star-shaped DCM derivatives, polycyclic aromatic hydrocarbons or non doped red fluorescent material containing D/A architecture; the material of the green fluorescent luminescent layer includes quinacridone derivatives, coumarin derivatives, polycyclic aromatic hydrocarbons; the material of the blue fluorescent luminescent layer includes diaryl anthracene derivatives, diphenyl ethylene araomatic derivatives, pyrene derivatives, spirobifluorene derivatives, TBP,DSA-Ph, IDE-102; the phosphorescent luminescent main body material may be main luminescent body material containing carbazole groups, main luminescent body material with electron transport property etc., whereas the phosphorescent doping material of red, green, and blue may be Pt complex, Ir complex, Eu complex, Os complex or FIrpic etc;
6. In the high vacuum evaporation chamber, forming a hole blocking layer, an electron transport layer, an electron injection layer and a cathode layer successively on the substrate on which the luminescent layer is formed by evaporating the bulk together in the evaporation chamber, wherein the hole blocking layer, the electron transport layer, the electron injection layer and the cathode layer are deposited successively using a mask plate of high precision, the material of the hole blocking layer may be BCP, the material of the electron transport layer may be quinoline derivatives, phenazine derivatives, heterocyclic compounds containing silicon, quinoxaline derivatives, dinitrogen phenanthrene derivatives or perfluorination oligomer, the material of the electron injection layer may be alkali metal oxide, and may also be alkali metal acetate, and may also be alkali metal fluoride; the material of the cathode layer may be Li:Al alloy or Mg:Ag alloy;
7. In the high vacuum evaporation chamber, forming a cathode protection layer on the substrate on which the cathode layer is formed by evaporating the bulk together in the evaporation chamber, wherein the cathode protection layer is deposited using an open mask plate, the cathode protection layer is used for protecting the whole OLED device from being eroded or oxidized.

Thus, the above organic electroluminescent display device provided by the embodiment of the present invention is fabricated through the above steps 1 to 7 provided by the example.

Based on the same inventive concept, the embodiment of the present invention further provides a display device comprising the above organic electroluminescent display device provided by the embodiment of the present invention, the display device may be any product or component with the display function such as a mobile phone, a tablet computer, a television, a display, a laptop, a digital photo frame, a navigator. For other necessary composite parts of the display device, all should be possessed and understood by the skilled person in the art, which will not be repeated here, and should not be taken as limitations to the present invention either. The implementation of the display device may refers to the embodiments of the above organic electroluminescent display device, which will not be repeated here.

The organic electroluminescent display device, the fabricating method thereof and the display device provided by the embodiment of the present invention comprise a substrate, a hole injection layer, a hole transport layer and an electron blocking layer arranged on the substrate successively, wherein the material of the hole transport layer is a material with P-type doping, the LUMO energy level of the P-type doping is relatively close to the HOMO energy level of the bulk material of the hole transport layer, hence, transition of the electrons in the HOMO energy level of the bulk material of the hole transport layer to the LUMO energy level of the P-type doping is enabled, thereby increasing the amout of free hole current carriers in the hole transport layer, and improving mobility of the hole current carrier, thus, it is convenient for increasing the probability of combining the electrons and the holes in the luminescent layer to form electron-hole pairs, so as to improve the balance degree of the electron-hole pairs, thereby improving luminescent performance of the OLED.

Apparently, the skilled person in the art can make various modifications and variations to the present invention without departing from the spirit and scope of the present invention. In this way, provided that these modifications and variations of the present invention belong to the scope of the claims of the present invention and the equivalent technologies thereof, the present invention also intends to contain these modifications and variations.

## Claims

1. An organic electroluminescent display device, comprising: a substrate, a hole injection layer, a hole transport layer and an electron blocking layer arranged on the substrate successively, **characterized in that**:
a material of the hole transport layer is a material with P-type doping.

2. The organic electroluminescent display device as claimed in claim 1, a doping concentration of the P-type doping presents gradient variation, so that energy level of the hole transport layer presents gradient variation; wherein,
the doping concentration of the P-type doping close to the hole injection layer is higher than the doping concentration of the P-type doping close to the electron blocking layer.

3. The organic electroluminescent display device as claimed in claim 2, **characterized in that** the highest occupied molecular orbital energy level difference between the hole transport layer and the electron blocking layer is less than the highest occupied molucular orbital energy level difference between an undoped hole transport layer and the electron blocking layer.

4. The organic electroluminescent display device as claimed in claim 2, **characterized in that** the highest occupied molecular orbital energy level difference between the hole injection layer and the hole transport layer is less than the highest occupied molecular orbital energy level difference between the hole injection layer and an undoped hole transport layer.

5. The organic electroluminescent display device as claimed in claim 2, **characterized in that** a minimum doping concentration of the P-type doping is 1%, a maximum doping concentration of the P-type doping is 6%.

6. The organic electroluminescent display device as claimed in claim 5, **characterized in that** a dopant used by the hole transport layer is P-type oxidant.

7. The organic electroluminescent display device as claimed in claim 6, **characterized in that** the P-type oxidant is any one of antimony pentachloride, iron chloride, iodine, 2,3,5,6-Tetrafluoro-7,7,8,8-tetracyanoquinodimethane or tris(4-bromophenyl)aminium hexachloroantimonate.

8. A fabricating method of an organic electroluminescent display device as claimed in any one of claims 1 to 7, comprising forming a hole injection layer, a hole transport layer and an electron blocking layer successively on a substrate, **characterized in that** wherein forming the hole tansport layer on the substrate specifically comprises:
forming the hole transport layer on the substrate on which the hole injection layer is formed by evaporating a bulk and a P-type doping together in an evaporation chamber.

9. The fabricating method as claimed in claim 8, **characterized in that** forming the hole transport layer on the substrate further comprises:
controlling a concentration of the P-type doping in the formed hole transport layer by controlling a temperature for evaporating the P-type doping.

10. A display device, **characterized in that**, comprising an organic electroluminescent display device as claimed in any one of claims 1 to 7.
